Europäisches Patentamt

European Patent Office

Office européen des brevets

(11) Numéro de publication : **0 301 979 B1**

## (12) FASCICULE DE BREVET EUROPEEN

(45) Date de publication du fascicule du brevet :
13.03.91 Bulletin 91/11

(21) Numéro de dépôt : 88420258.1

(22) Date de dépôt : 20.07.88

(51) Int. Cl.⁵ : **H03K 17/04**

(54) Circuit de commande de base en pont à blocage contrôlé même en avalanche.

(30) Priorité : 21.07.87 FR 8710605

(43) Date de publication de la demande :
01.02.89 Bulletin 89/05

(45) Mention de la délivrance du brevet :
13.03.91 Bulletin 91/11

(84) Etats contractants désignés :
CH DE ES GB IT LI NL SE

(56) Documents cités :
EP-A- 0 119 904

(56) Documents cités :
PROCEEDINGS OF THE INTERNATIONAL
CONFERENCE ON INDUSTRIAL ELECTRO-
NICS, CONTROL AND INSTRUMENTATION,
IECON '84, Tokyo, 22-26 octobre 1984, vol. 1,
pages 149-154; K. KAWAGISHI et al.:
"Acoustic noiseless sinusoidal PWM inverter
employing BI-MOS"

(73) Titulaire : SGS-THOMSON
MICROELECTRONICS S.A.
7, Avenue Galliéni
F-94250 Gentilly (FR)

(72) Inventeur : Patni, Chandra Kumar
1319, Chemin de St. Donat
F-13100 Aix en Provence (FR)

(74) Mandataire : de Beaumont, Michel et al
1bis, rue Champollion
F-38000 Grenoble (FR)

## Description.

La présente invention concerne la commande de base d'interrupteurs de puissance tels que, par exemple, des transistors de puissance, des transistors à montage Darlington ou des transistors à montage cascode.

La présente invention concerne plus particulièrement un tel circuit de commande de base en pont du type décrit dans la demande de brevet français FR-A-2 542 948. Ce type de circuit permet de faire passer un courant dans la base du transistor de puissance quand on veut qu'il soit conducteur, puis, au moment de l'ouverture du transistor de puissance, d'extraire un courant de base (courant de base négatif dans le cas d'un transistor NPN) jusqu'à ce que les charges stockées dans ce transistor soit éliminées.

Un avantage des circuits en pont est que ce résultat peut être obtenu avec une source de tension de polarité unique.

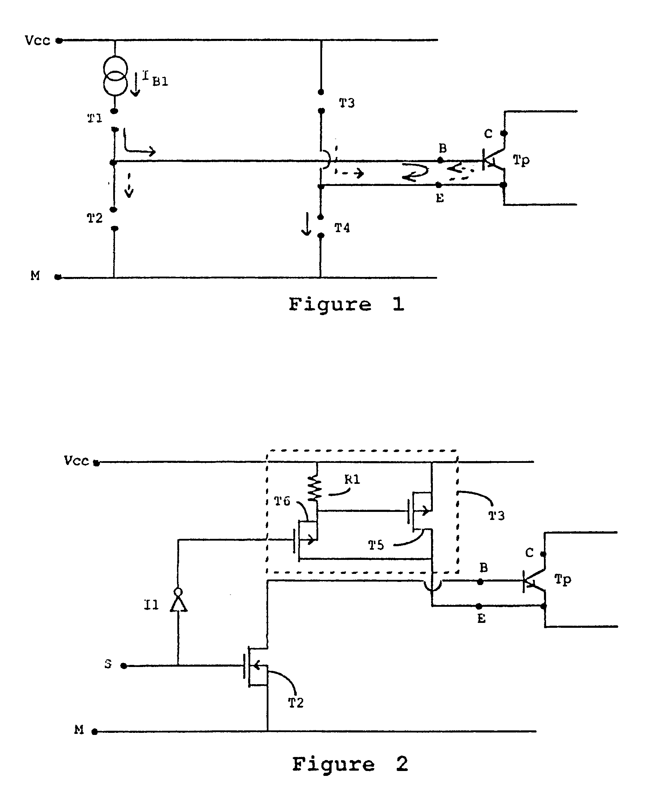

La figure 1 représente un exemple de montage de commande de base en pont classique. Un transistor de puissance TP à commuter comprend des bornes de base, B, d'émetteur, E, et de collecteur, C. Un pont de commutation comprend quatre commutateurs T1 à T4 connectés entre une borne d'alimentation Vcc et une borne de référence M. Plus particulièrement, le commutateur T1 est connecté entre la tension Vcc et la borne de base B, le commutateur T2 est connecté entre cette borne de base B et la borne de référence M, le commutateur T3 est connecté entre la borne d'alimentation Vcc et la borne d'émetteur E, et le commutateur T4 est connecté entre la borne E et la borne de référence M.

Ainsi, dans un premier état, les commutateurs T2 et T3 sont ouverts et les commutateurs T1 et T4 sont fermés et un courant de base fourni par une source de courant IB1 circule de la tension d'alimentation Vcc à la borne B, la borne E et la borne de référence M en passant par les commutateurs fermés T1 et T4 selon la trajet de courant indiqué par les flèches en trait plein.

A l'ouverture, les commutateurs T1 et T4 sont ouverts et les commutateurs T3 et T2 sont fermés. Ainsi, un courant inverse circule à partir de la borne d'alimentation Vcc par le commutateur T3, la borne E, la borne B, le commutateur T2 vers la borne de référence M.

Comme l'indique par exemple, en page 99, l'ouvrage publié par la Société THOMSON CSF en 1983 sous le titre "Le transistor de puissance dans la conversion d'énergie", ouvrage ayant également fait l'objet d'une publication en langue anglaise, un inconvénient de ce type de circuit à extraction de courant de base dans lequel on applique, à l'ouverture, une tension inverse entre l'émetteur et la base est que, si la tension Vcc est trop élevée, une fois que les charges stockées au voisinage de la jonction émetteur-base sont ont été évacuées, la jonction émetteur-base risque de claquer en avalanche interne. Il en résulte une dissipation de courant importante dans le circuit de commande. Différents systèmes ont déjà été proposés pour pallier cet inconvénient, mais aucun n'y remédie de façon parfaite ou de façon simple.

Ainsi, un objet de la présente invention est de remédier à cet inconvénient.

Un autre objet de la présente invention est de prévoir un circuit de commande de base en pont dans lequel la conduction du transistor principal est assurée selon le procédé dit "switch mode" (commande par commutation).

Un autre objet de la présente invention est de prévoir un circuit de commande de base en pont à très faible consommation.

Un autre objet de la présente invention est de prévoir un circuit de commande de base en pont dans lequel diverses sécurités sont prévues pour assurer un fonctionnement sûr et fiable du système.

Ces objets de l'invention sont atteints en prévoyant un circuit de commande de base en pont pour interrupteur de puissance dans lequel, à l'ouverture, la base est reliée à une borne de référence par un premier moyen de commutation à faible impédance et l'émetteur est relié à une borne d'alimentation par un deuxième moyen de commutation pour permettre le passage d'un courant inverse dans la jonction base-émetteur, et dans lequel le deuxième moyen de commutation présente une faible impédance tant que la tension d'émetteur est faible, immédiatement après sa fermeture et celle du premier moyen de commutation, et une impédance plus élevée dès que la tension d'émetteur se rapproche de la tension d'alimentation, cette transition se faisant de façon automatique.

Selon un aspect de la présente invention, le deuxième moyen de commutation comprend, d'une part, un interrupteur principal du type devenant conducteur quand la différence de potentiel entre sa première borne principale et sa borne de commande est supérieure à un seuil déterminé, cette première borne principale étant connectée à la borne d'alimentation et la deuxième borne principale étant reliée à la borne d'émetteur et, d'autre part, un interrupteur auxiliaire connecté entre la borne de commande et la deuxième borne principale, et une résistance connectée entre la borne de commande et la première borne principale.

Selon un aspect de la présente invention, les interrupteurs principal et auxiliaire sont des transistors MOS à appauvrissement à canal P.

Selon un aspect de la présente invention, les interrupteurs principal et auxiliaire sont des transistors bipolaires de type PNP.

Selon un aspect de la présente invention, la branche du pont assurant la fourniture d'un courant de base pour la fermeture de l'interrupteur de puissance est du type à source de courant à commutation, comprenant un interrupteur commandé en série avec une inductance.

Selon un aspect de la présente invention, le circuit de commande comprend une source d'ordre de basculement munie de moyens d'inhibition quand le fonctionnement de l'interrupteur de puissance apparaît comme défectueux.

Ainsi, avec le montage selon la présente invention, à l'ouverture, dès que l'émetteur est déstocké et que sa tension monte par rapport à la base qui est connectée à la masse, une résistance de limitation de courant est introduite de façon automatique dans le circuit, ce qui interrompt l'effet d'avalanche ou à tout le moins limite le courant d'avalanche à une faible valeur.

Ces objets, caractéristiques et avantages ainsi que d'autres de la présente invention seront exposés plus en détail dans la description suivante d'un mode de réalisation particulier faite en relation avec les figures jointes parmi lesquelles :

la figure 1, décrite précédemment, représente un circuit de commande de base en pont selon l'art antérieur ;

la figure 2 représente les branches du circuit en pont selon l'invention servant au passage du courant lors d'une commutation à l'ouverture ;

la figure 3 représente un mode de réalisation d'un circuit de commande de base en pont selon la présente invention ;

la figure 4 représente un mode de réalisation d'un circuit logique de fourniture de signal d'ordre de commutation pour le circuit de commande de base de la figure 3 ;

la figure 5 représente sous forme généralisée un moyen de commutation utilisé dans la mise en oeuvre de la présente invention ; et

la figure 6 représente des courbes caractéristiques du moyen de commutation de la figure 5.

Comme cela a été indiqué en relation avec la figure 1, quand on veut commuter à l'ouverture un circuit de commande de base en pont, les commutateurs T1 et T4 sont ouverts et les commutateurs T2 et T3 sont fermés.

La figure 2 représente le cas où l'ordre de commutation à l'ouverture a été donné et représente les seules branches du pont laissant passer un courant, c'est-à-dire les branches comprenant les commutateurs T3 et T2.

Le commutateur T2 est réalisé sous forme d'un transistor MOS à canal N.

Le commutateur T3 comprend deux transistors MOS à canal P, T5 et T6 et une résistance R1 ayant par exemple une valeur de 1 kilohm. La source du transistor T5 est reliée à la borne d'alimentation Vcc, le drain du transistor T5 est relié à la borne d'émetteur et la grille du transistor T5 est reliée à une première borne de la résistance R1 et à la source du transistor T6. L'autre borne de la résistance R1 est reliée à la borne d'alimentation Vcc, c'est-à-dire à la source du transistor T5. Le drain du transistor T6 est relié avec le drain du transistor T5 à la borne d'émetteur E et la grille du transistor T6 reçoit un signal S d'ordre d'ouverture du transistor de puissance TP par l'intermédiaire d'un inverseur I1, ce signal d'ordre S étant appliqué directement à la grille du transistor à canal N T2.

Ainsi, dès qu'un signal S est appliqué pour commander l'ouverture du transistor de puissance TP, les commutateurs T1 et T4 (non représentés en figure 2) sont immédiatement ouverts et les transistors T2 et T6 deviennent conducteurs. La conduction du transistor T6 entraîne celle du transistor T5. Un courant circule donc entre la borne d'alimentation Vcc et la borne de masse M par l'intermédiaire du transistor T5, de la jonction émetteur-base en inverse du transistor de puissance TP et du transistor T2.

Dans une première phase, la borne de base B se trouve sensiblement au potentiel de la masse et, en raison des charges stockées, la borne d'émetteur E est à un potentiel voisin de celui de la base, par exemple à une tension de l'ordre de 1,5 Volt. Cette tension sur la borne E se retrouve, par l'intermédiaire du transistor T6 sur la grille du transistor T5. Ce transistor conduit donc bien, puisque le potentiel sur sa source (Vcc) est nettement supérieur au potentiel sur la grille (quelques volts).

Ensuite, tandis que les charges stockées dans la base commencent à s'éliminer, la tension sur la borne d'émetteur E monte par rapport à la tension sur la base et cette tension tend à se rapprocher de Vcc. Un transistor MOS à canal P, tel que le transistor T5, cesse de conduire quand la différence de tension entre sa source et sa grille devient inférieure à un certain seuil. En conséquence, quand le transistor TP commence à se bloquer et que la tension sur son émetteur croît, le transistor T5 se bloque. Par contre, le transistor T6 reste conducteur et donc l'application de potentiel sur la borne E est maintenue par la liaison vers la borne Vcc assurée par le transistor T6 et la résistance de limitation de courant R1. Un avantage de cette structure est que, si le transistor T5 était resté conducteur, et que la tension Vcc est plus élevée que la tension d'avalanche émetteur-base du transistor de puissance TP, il se produirait une mise en avalanche de la jonction émetteur-base de ce transistor TP. Un courant important serait en conséquence dissipé dans le circuit de commande de base.

Grâce à la structure représentée du commutateur T3, dès que le transistor de puissance est bloqué, la résistance R1 vient se mettre en série avec la jonction émetteur-base et donc, s'il se produit une avalanche, le courant d'avalanche est extrêmement limité.

Le circuit de la figure 2 à été représenté en relation avec un mode de réalisation particulier pour bien faire comprendre le fonctionnement de l'invention. Il est toutefois clair que d'autres éléments présentant les mêmes fonctions pourraient être utilisés. Par exemple, les transistors T5 et T6 au lieu d'être des transistors MOS à canal P pourraient être des transistors bipolaires de type PNP. D'autre part, on a considéré le cas où le transistor de puissance est un transistor NPN, ce qui est le cas le plus général. Toutefois, si l'on voulait commander un transistor PNP, il suffirait de modifier de façon correspondante les tensions d'alimentation et les types des divers transistors.

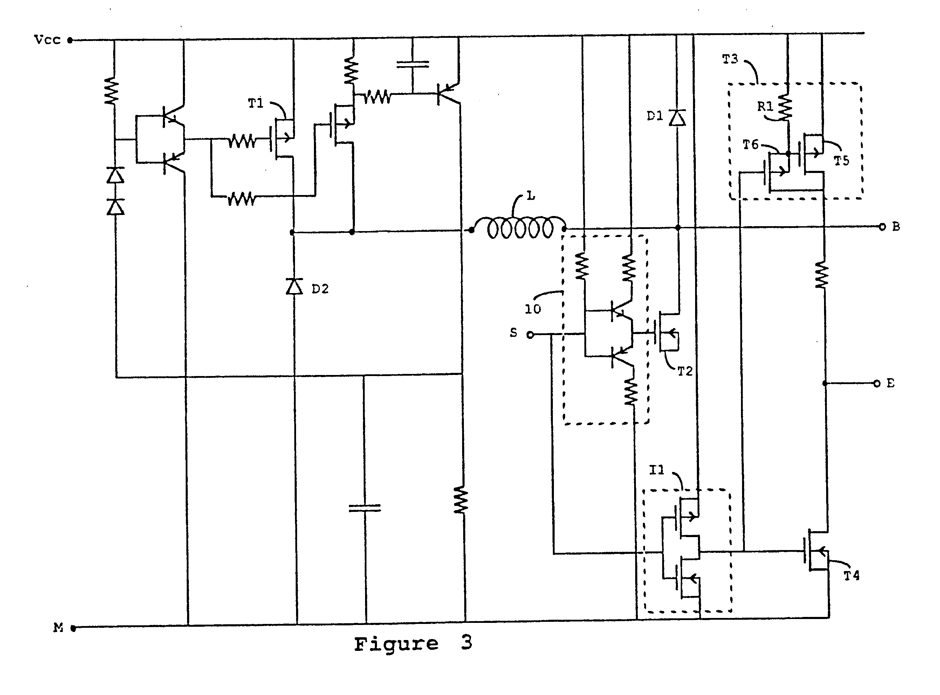

La figure 3 représente la structure générale d'un mode de réalisation de circuit de commande de base en pont selon l'invention dans lequel d'autres perfectionnements ont été apportés en sus de ceux décrits en relation avec la figure 2. On retrouve en figure 3 les bornes d'alimentation Vcc et M, les commutateurs T1, T2, T3 et T4 représentés en figure 1, les éléments T5, T6, R1 et I1 décrits en relation avec la figure 2.

Dans le montage de la figure 3, on a adopté pour la source de courant IB1, illustrée symboliquement en figure 1 dans la branche T1, un système couramment désigné dans la technique par l'appellation anglosaxonne "switch-mode", c'est-à-dire à fonctionnement par impulsions, qui présente l'avantage de permettre une réduction importante de la consommation du circuit de commande de base et d'être simplement réglable. L'adaptation particulière de ce circuit de type "switch-mode" à un montage en pont constitue l'un des aspects de la présente invention.

Ainsi, la branche 1 du pont, connectée entre la borne d'alimentation Vcc et la borne de base B, comprend un transistor T1 du type MOS à canal P en série avec une inductance L. Une première diode D1 est connectée entre la borne B et la borne d'alimentation Vcc et une deuxième diode D2 est connectée entre la borne de référence M et le point de raccordement du transistor T1 et de l'inductance L. Le transistor T1 fonctionne en commutation à haute fréquence, l'inductance L, en relation avec les diodes D1 et D2, fournissant un courant lissé à la borne de base B quand on est dans le mode fermeture de transistor TP et que le commutateur T4, réalisé sous forme d'un transistor MOS à canal N, est fermé.

On notera que le circuit en pont selon la figure 3 permet d'effectuer des commutations à l'ouverture ou à la fermeture en agissant seulement sur les commutateurs T2, T3 et T4, le transistor T1 continuant à être commandé à haute fréquence, les trajets de courant se refermant par les diodes D1 et D2. Ceci constitue un avantage de la présente invention car on dispose ainsi à tout instant du courant de base nécessaire pour mettre en conduction le transistor TP.

L'inverseur I1 est constitué classiquement de deux transistors MOS complémentaires dont les grilles et les drains sont respectivement interconnectés.

A l'entrée du transistor T2 (transistor MOS à canal N), un étage tampon ou étage adaptateur 10 comprend des transistors bipolaires, respectivement NPN et PNP, connectés par leurs bases et par leurs émetteurs, respectivement, en relation avec des résistances de polarisation appropriées.

En relation avec le transistor T1, on a représenté un exemple de circuit oscillant. Ce circuit ne sera pas décrit en détail ici étant donné qu'il pourra être simplement compris de l'homme de l'art. Il a été seulement représenté pour indiquer que sa réalisation est compatible avec les technologies de fabrication des autres éléments. En effet, tous les éléments représentés en figure 3, à l'exception de l'inductance L, peuvent être réalisés sur un circuit intégré unique en utilisant une technologie permettant d'intégrer simultanément des transistors MOS complémentaires et des transistors bipolaires de types différents.

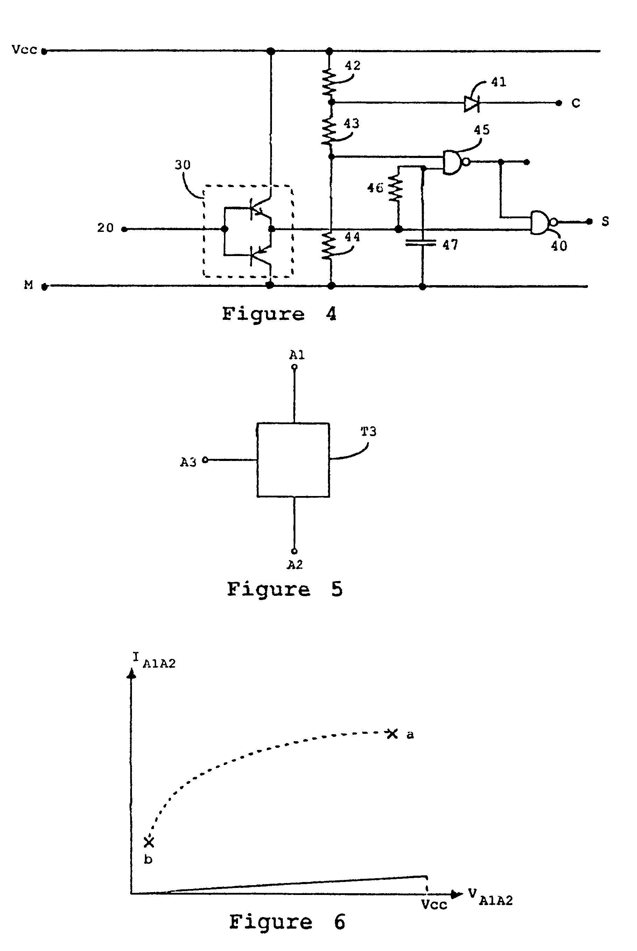

On peut voir en figure 3 que l'état de commutation des commutateurs T2, T3 et T4 dépend d'un signal extérieur S. Un moyen de fourniture de ce signal est illustré en figure 4. Le circuit de la figure 4 permet de transformer un signal logique incident 20 en le signal S tout en fournissant certaines sécurités pour le circuit. Le signal 20 à haut ou bas niveau est d'abord envoyé à un circuit tampon ou circuit adaptateur d'impédance 30 dont la sortie est connectée à une première entrée d'une porte NON ET (ou porte NI) 40. La porte NON ET 40 transmet normalement un signal S inverse du signal 20. L'autre entrée de cette porte NON ET 40 est destinée à assurer une sécurité, c'est-à-dire à interrompre la fourniture du signal de commande de base du transistor principal si celui-ci apparaît défectueux, et plus particulièrement si sa tension de collecteur n'est pas à bas niveau peu après la fourniture de l'ordre de fermeture. Pour ce faire, la tension sur la borne de collecteur C est détectée par une diode 41 connectée à des résistances en série 42, 43 et 44 de la façon représentée. A titre d'exemple, les résistances 42, 43 et 44 peuvent avoir des valeurs respectives de 10, 22 et 56 kilohms. L'information sur le niveau de tension du collecteur C, c'est-à-dire la tension au point de raccordement des résistances 42 et 43 est transmise à une première entrée d'une deuxième porte NON ET 45 connectée entre les résistances 43 et 44. L'autre entrée de la deuxième porte NON ET 45 est connectée à la borne 20 par l'intermédiaire d'une résistance 46 et est connectée à la borne M par l'intermédiaire d'un condensateur 47. Ainsi, le signal sur la borne 20 est transmis à la deuxième entrée de la porte NON ET 45 avec un certain retard lié à la constante de temps du circuit RC 46, 47. La sortie de la porte 45 est envoyée à la deuxième entrée de la porte 40.

Ce circuit logique fonctionne de la façon suivante. A l'état initial, quand un ordre de fermeture est envoyé sur la porte 20, la porte NON ET 40 est validée et un signal S est fourni au circuit de commande de base. Ensuite, avec un retard lié à la constante de temps susmentionnée, la porte NON ET 45 est validée pour laisser passer l'information de tension élevée sur le collecteur C si cet état est présent, c'est-à-dire qu'il existe un défaut. Alors, en ce cas, la porte 40 est invalidée, le signal S n'est plus fourni et la conduction des commutateurs T1, T2, T3, T4 s'inverse. On comprendra que le temps de retard assuré par le circuit RC 46, 47 est destinée à laisser à la tension de collecteur le temps de chuter immédiatement après fourniture de l'ordre de fermeture.

On notera que le signal à la sortie de la porte 45 peut être utilisé comme signal d'état indiquant l'état de conduction ou de non-conduction du transistor de puissance TP.

Dans la pratique, le circuit de la figure 4 pourra être intégré en un composant semiconducteur unique avec les divers composants du circuit de commande de base de la figure 3.

Bien entendu, les circuits des figures 3 et 4 ne constituent que des exemples particuliers de réalisation de la présente invention. Il s'agit d'un ensemble cohérent de composants permettant une intégration. Toutefois, on notera que d'autres types de composants pourraient être utilisés ; par exemple les transistors MOS pourraient être remplacés par des montages à transistors bipolaires pour autant que ceux-ci présentent une rapidité de commutation et des résistances aux états passant et bloqué satisfaisantes.

D'autre part, une réalisation particulière du commutateur T3 selon la présente invention a été illustrée en figures 2 et 3. Plus généralement, comme le représente la figure 5, ce commutateur T3 peut être considéré comme un tripôle comprenant deux bornes principales A1 et A2 et une borne de commande A3.

Ce tripôle a la caractéristique électrique illustrée en figure 6.

Tout d'abord, quand le signal de commande appliqué sur la borne A3 est à l'état "OFF" le commutateur T3 est à l'état bloqué comme le représente la courbe inférieure en trait plein de la figure 6. Ainsi, quand la tension $V_{A1A2}$ entre ces bornes A1 et A2 augmente, le courant $I_{A1A2}$ traversant ce commutateur reste pratiquement nul (la pente de la droite en trait plein a été exagérée dans la figure).

Par contre, quand le signal sur la borne de commande A3 est à l'état "ON" ce commutateur présente deux points de fonctionnement principaux. Au point a, quand la tension entre les bornes principales A1 et A2, $V_{A1A2}$, est élevée, le moyen de commutation T3 est dans un état de faible impédance et laisse passer un courant élevé à une valeur optimisée pour le déstockage du transistor TP tandis que la tension $V_{BE}$ du transistor TP est faible. Au point a, la tension $V_{A1A2}$ peut être choisie d'une manière quelconque, y compris une valeur supérieure à la tension d'avalanche de la jonction base-émetteur du transistor principal TP.

Au point b, quand la tension $V_{A1A2}$ est faible, le deuxième moyen de commutation T3 limite le courant $I_{A1A2}$ à une valeur suffisamment faible pour limiter l'énergie dissipée dans la jonction base-émetteur du transistor TP même en cas d'avalanche de cette dernière à une valeur non destructive pour ce transistor TP. On comprendra que la représentation de la figure 6 est à échelle logarithmique, l'impédance étant plus élevée au point b qu'au point a. La transition entre les points a et b peut se faire selon une caractéristique quelconque, par exemple comme celle représentée sur la figure 5 en traits pointillés.

**Revendications**

1. Circuit de commande de base en pont pour interrupteur de puissance (TP), dont la tension base-émetteur (VBE) est faible à la conduction et initialement faible à l'ouverture en raison de la présence de charges stockées pendant la phase antérieure de conduction, dans lequel, à l'ouverture, la base est reliée à une borne de référence (M) par un premier moyen de commutation (T2) à faible impédance et l'émetteur est relié à une borne d'alimentation (Vcc) par un deuxième moyen de commutation (T3) pour permettre le passage d'un courant inverse dans la jonction base-émetteur,
caractérisé en ce que le deuxième moyen de commutation comprend une première voie à faible impédance, active immédiatement après la fermeture des premier et deuxième moyens de commutation et tant que la tension base-émetteur ($V_{BE}$) de l'interrupteur de puissance est faible, et une deuxième voie à impédance plus élevée active dès que la tension d'émetteur se rapproche de la tension d'alimentation (Vcc).

2. Circuit de commande de base selon la revendication 1, caractérisé en ce que le deuxième moyen de commutation comprend :
   – un interrupteur principal (T5) du type devenant conducteur quand la différence de potentiel entre sa première borne principale et sa borne de commande est supérieure à un seuil déterminé, cette première borne principale étant connectée à la borne d'alimentation et la deuxième borne principale étant reliée à la borne d'émetteur,
   – un interrupteur auxiliaire (T6) connecté entre la borne de commande de l'interrupteur principal et la deuxième borne principale et dont la borne de commande reçoit le signal de commande d'ouverture de l'interrupteur de puissance, et
   – une résistance (R1) connectée entre la borne de commande de l'interrupteur principal et la première borne principale.

3. Circuit de commande de base selon la revendication 2, caractérisé en ce que les interrupteurs principal et auxiliaire sont des transistors MOS à appauvrissement à canal P.

4. Circuit de commande de base selon la revendication 2, caractérisé en ce que les interrupteurs principal et auxiliaire sont des transistors bipolaires de type PNP.

5. Circuit de commande de base selon l'une quelconque des revendications 1 à 4, caractérisé en ce que la branche du pont assurant la fourniture d'un courant de base pour la fermeture de l'interrupteur de puissance est du type source de courant à commutation, comprenant un interrupteur (T1) commandé par un signal haute fréquence.

6. Circuit de commande de base selon la revendication 5, caractérisé en ce que la branche du pont connectée entre la borne d'alimentation (Vcc) et la base (B) du commutateur de puissance comprend :

   – un transistor à effet de champ à canal P (T1) commandé par un signal oscillant, en série avec une inductance (L),

   – une première diode (D1) connectée entre la borne de l'inductance reliée à la borne de base (B) et la tension d'alimentation (Vcc), et

   – une deuxième diode (D2) connectée entre l'autre borne de l'inductance (L) reliée au transistor (T1) et la tension de référence (M), ces diodes (D1 et D2) étant polarisées toutes deux en inverse dans le circuit allant de la tension d'alimentation à la tension de référence en passant par ces diodes.

7. Circuit de commande de base selon l'une quelconque les revendications 1 à 6, caractérisé en ce qu'il comprend une source d'ordres de basculement (20, 30) destinés aux diverses branches du pont, cette source étant munie de moyens d'inhibition (40-47) agissant quand le fonctionnement de l'interrupteur de puissance apparaît comme défectueux.

## Ansprüche

1. Brückenbasis-Steuerschaltkreis für einen Leistungsschalter, dessen Basis-Emitter-Spannung (VBE) im leitenden Zustand niedrig ist und beim Öffnen anfangs aufgrund der Anwesenheit von während der vorangegangenen Leitungsphase gespeicherten Ladungen niedrig ist, wobei beim Öffnen die Basis durch eine erste Schalteinrichtung (T2) geringer Impedanz mit einem Referenzanschluß (M) verbunden ist und der Emitter durch eine zweite Schalteinrichtung (T3) mit einem Stromanschluß (Vcc) verbunden ist, um einen Reststromfluß in der Basis-Emitter-Verbindung zu ermöglichen, **dadurch gekennzeichnet**, daß die zweite Schalteinrichtung einen ersten Pfad geringer Impedanz, welcher unmittelbar nach dem Schließen der ersten und zweiten Schalteinrichtung und solange die Basis-Emitter-Spannung (VBE) des Leistungsschalters niedrig ist, aktiv ist, und einen zweiten Pfad höherer Impedanz, der aktiv wird, sobald sich die Emitterspannung der Speisespannung (Vcc) nähert, aufweist.

2. Basis-Steuerschaltkreis nach Anspruch 1, dadurch gekennzeichnet, daß die zweite Schalteinrichtung

   – einen Hauptschalter (T5) eines Typs, der leitend wird, wenn die Spannungsdifferenz zwischen seinem ersten Hauptanschluß und seinem Steueranschluß höher ist als ein festgelegter Schwellenwert, wobei dieser Hauptanschluß mit dem Stromanschluß verbunden ist und der zweite Hauptanschluß an den Emitteranschluß gelegt ist,

   – einen zwischen den Steueranschluß des Hauptschalters und den zweiten Hauptschalter gelegten Hilfsschalter (T6), dessen Steueranschluß das Steuersignal des Öffnens des Leistungsschalters empfängt, und

   – einen zwischen den Steueranschluß des Hauptschalters und den zweiten Hauptschalter gelegten Widerstand (R1) aufweist.

3. Basis-Steuerschaltkreis nach Anspruch 2, dadurch gekennzeichnet, daß Haupt- und Hilfsschalter Verarmungs-P-Kanal-MOS-Transistoren sind.

4. Basis-Steuerschaltkreis nach Anspruch 2, dadurch gekennzeichnet, daß Haupt- und Hilfsschalter bipolare PNP-Transistoren sind.

5. Basis-Steuerschaltkreis nach einem der Ansprüche 1 bis 4, dadurch gekennzeichnet, daß der Brückenzweig, der den Zufluß eines Basisstromes zum Schließen des Leistungsschalters sichert, vom Stromquellenschaltungstyp ist, der einen von einem Hochfrequenzsignal gesteuerten Schalter (T1) aufweist.

6. Basis-Steuerschaltkreis nach Anspruch 5, dadurch gekennzeichnet, daß der zwischen den Stromanschluß (Vcc) und die Basis (B) des Leistungsschalters liegende Brückenzweig

   – einen P-Kanal-Feldeffekttransistor (T1), gesteuert durch ein oszillierendes Signal, in Reihe mit einer Induktivität (L) aufweist,

   – eine erste Diode (D1), die zwischen den mit dem Basisanschluß (B) verbundenen Induktivitätsanschluß und die Speisespannung (Vcc) gelegt ist, und

   – eine zweite Diode (D2), die zwischen den anderen, mit dem Transistor (T1) verbundenen Induktivitätsanschluß (L) und die Referenzspannung (M) gelegt ist, wobei beide Dioden (D1 und D2) in dem Schaltkreis, der von der Speisespannung zur Referenzspannung durch die Dioden verläuft, entgegengesetzt unter Vorspannung gebracht sind, aufweist.

7. Basis-Steuerschaltkreis nach einem der Ansprüche 1 bis 6, dadurch gekennzeichnet, daß er eine Quelle für eine Anzahl von Kippsignalen (20, 30) für die verschiedenen Brückenzweige aufweist, wobei diese Quelle mit Inhibitionseinrichtungen (40-47) versehen ist, welche wirksam sind, wenn die Funktion des Leistungsschalters fehlerhaft erscheint.

## Claims

1. A bridge base control circuit for a power switch (TP), having an initially low base-emitter voltage ($V_{BE}$) at the switching off due to charges stored during the former ON state, wherein, at the switching off, the base is connected with a reference terminal (M) through a first switching means (T2) with a low impedance and the emitter is connected with a supply terminal (Vcc) through a second switching means (T3) for allowing the flowing of a reverse current in the base-emitter junction, characterized in this that the second switching means comprises a first path having a low impedance, active immediately after the closing of the first and second switching means and as long as the base-emitter voltage ($V_{BE}$) of the power switch is low, and a second path with a higher impedance, active as soon as the emitter voltage approaches the supply voltage (Vcc).

2. A base control circuit according to claim 1, characterized in this that the second switching means comprises :

— a main switch (T5) becoming conductive when the voltage difference between its first main terminal and its control terminal is higher than a determined threshold, this first main terminal being connected with the supply terminal and the second main terminal being connected with the emitter terminal ;

— an auxiliary switch (T6) connected between the control terminal of the power switch and the second main terminal and the control terminal of which receives the switching off control signal of the power switch ; and

— a resistor (R1) connected between the control terminal of the main switch and the first main terminal.

3. A base control circuit according to claim 2, characterized in this that the main and auxiliary switches are P-channel depletion MOS transistors.

4. A base control circuit according to claim 2, characterized in this that the main and auxiliary switches are PNP-type bipolar transistors.

5. A base control circuit according to any of claims 1 to 4, characterized in this that the bridge leg ensuring the supply of the base current for the switching on of the power switch is of the switching current source type, comprising a switch (T1) controlled by a high frequency signal.

6. A base control circuit according to claim 5, characterized in this that the bridge leg connected between the supply terminal (Vcc) and the base (B) of the power switch comprises :

— a P-channel field effect transistor (T1) controlled by an oscillating signal, in series with an inductance (L) :

— a first diode (D1) connected between the inductance terminal coupled with the base terminal (B) and the supply voltage (Vcc) ; and

— a second diode (D2) connected with the other inductance terminal coupled with said field effect transistor (T1) and the reference voltage (M), said diodes (D1 and D2) being reverse biased in the circuit extending from the supply voltage to the reference voltage through said diodes.

7. A base control circuit according to any of claims 1 to 6, characterized in this that it comprises a source of control signals (20, 30) for the various legs of the bridge, said source being provided with inhibition means (40-47) acting when the power switch operation proves to be faulty.

Figure 1

Figure 2

Figure 3

Figure 4

Figure 5

Figure 6